# EUROPEAN PATENT APPLICATION

(11) **EP 1 195 772 A1**
(43) Date of publication of application: **10.04.2002**
(21) Application number: 01000294.7
(22) Date of filing: 12.07.2001
(51) Int. Cl.: G11C 17/18

(54) **Fuse circuit**

(30) Priority: 12.07.2000 US 614342
(71) Applicant: Texas Instruments Inc., Dallas, Texas 75251 (US)
(72) Inventor: Iroaga, Echere, Garland, Texas 75063 (US); Bloodworth, Bryan E., Irving, Texas 75263 (US)
(74) Representative: Holt, Michael

(57) **Abstract**

The present invention provides an apparatus and method of fuse trimming for a variable mode circuit. The apparatus comprises a circuit which includes two trim fuses connectable to a power supply, a first circuit portion, and a variable voltage fuse interpreter. The first circuit portion is adapted to control the passing of a diffuse current through the trim fuses and is adapted to control the passing of a margin and unmargin test current through the trim fuses. The variable voltage fuse interpreter determines the status of each fuse (i.e., blown or unblown) corresponding to the margin and unmargin test currents and provides a digital output as a predetermined function of the fuse status for each of the test currents.

## Description

### Technical Field of the Invention

The present invention relates to semi-conductor devices and circuits and, more particularly, to a variable sensing fuse circuit and method.

### Description of Related Art

Generally, mass storage devices, such as hard disk drives, include a magnetic storage media, such as rotating disk or platters, a spindle motor, read/write heads, an actuator, a preamplifier, a read channel, a write channel, a servo circuit, and control circuitry to control the operation of hard disk drive and to properly interface the hard disk drive to a host system or bus.

Writing data is typically performed by applying a current to a coil of the head so that a magnetic field is induced in the adjacent magnetic permeable core, with the core transmitting a magnetic signal across a spacing and protective coating of the disk to magnetize a small pattern or digital bit of the media within the disk. Reading of the information in the disk is performed by sensing the change in magnetic field of the core as the transducer passes over the bits in the disk. The changing magnetic field induces a voltage or current in the inductive coupled coil. Alternatively, reading of the information may be accomplished by employing a magneto resistive sensor, which has a resistance that varies as a function of the magnetic field adjacent to the sensor.

Recently, some manufacturers of disk storage devices have switched to modes which allow writing to multiple heads simultaneously. Using a normal supply voltage, when writing to multiple heads, increases power dissipation and heating of the integrated circuits. Consequently, lower voltage and current are used for multiple writing modes to reduce power requirements and heat. Therefore, integrated circuits employed to support disk storage devices must be able to support the variable voltage and current characteristic requirements of different modes of read/write heads employed. Currently, separately designed integrated circuits are employed for modes which write to only one head and modes which write to multiple heads. The reason for the separately designed integrated circuits is, at least in part, due to limitations in fuse trimming techniques used for integrated circuits.

The process known as fuse trimming is currently used which allows a manufacturer to correct for process variations in integrated circuits and make other small operating adjustments. Processing variations in the fabrication of semi-conductor integrated circuits often prevent the manufacturer of component, such as resistors and capacitors, with precise values. For example, an unblown fuse can be used to selectively connect additional elements to create a first output or a second output if the fuse is blown or diffused. Also, a fuse can be included in a response circuit designed to give a first output response with an unblown fuse and a second output response with a blown fuse in which the output also serves as an input to, for example, a current DAC for making small current adjustments. For consistent results, the fuse trimming process also requires that the status of the fuse be accurately determined (i.e., short or open).

Currently used fuse trimming circuits lead to inconsistent fuse status determination when applied to variable supply potentials. For example, a fuse trimming circuit used to support a disk storage device writing to a single head and operating at a supply potential of approximately 8 volts may accurately determine fuse status, however, when this circuit is used to support multiple writing modes which operate at a lower supply potential (approximately 4.5 volts), fuse status interpretation becomes inconsistent (i.e., fuses that should be interpreted as short are often interpreted as open). This ambiguity creates a situation in which indeterminate logic outputs may be created thereby rendering the circuit useless. Consequently, current fuse trimming circuits are not interchangeable with different voltage supply modes requiring separately designed fuse trimming circuits for each type writing mode. The above-mentioned multi-mode disk storage device describes only one example of the need for a fuse trimming circuit adapted for multiple operation voltage supplies.

### SUMMARY OF THE INVENTION

The present invention achieves technical advantages as an apparatus and method of fuse trimming for a variable mode circuit. The apparatus comprises a circuit which includes two fuses, in a preferred embodiment, connectable to a power supply. The fuses are also connected to a first circuit portion adapted to control the passing of a large current through the fuses, thus, blowing the fuses. The first circuit portion also includes circuitry adapted to control the passing of a first and second test current in a preferred embodiment. The fuses are also connected to a second circuit portion or fuse interpreter for interpreting the status of the fuses (i.e., open or short). The fuse interpreter also includes logic circuitry for controlling a digital output in which the digital output is a predetermined function of the fuses' status at each of the test currents. The logic circuitry is also adapted to operate at multiple power supply potentials.

### BRIEF DESCRIPTION OF THE DRAWINGS

For a more complete understanding of the present invention, reference is made to the following detailed description taken in conjunction with the accompanying drawings wherein:
Figure 1 illustrates a method of fuse trimming in accordance with the present invention;
Figure 2 illustrates a block diagram of a fuse circuit with a variable voltage fuse interpreter in accordance with the present invention;
Figure 3 illustrates a preferred fuse circuit with a variable voltage fuse interpreter in accordance with the present invention; and
Figure 4 illustrates a preferred control logic chart in accordance with the present invention.

### DETAILED DESCRIPTION OF THE INVENTION

The numerous innovative teachings of the present applications will be described with particular reference to the presently preferred exemplary embodiments. However, it should be understood that this class of embodiments provides only a few examples of the many advantageous uses and innovative teachings herein. In general, statements made in the specification of the present application do not necessarily delimit any of the various claimed inventions. Moreover, some statements may apply to some inventive features, but not to others.

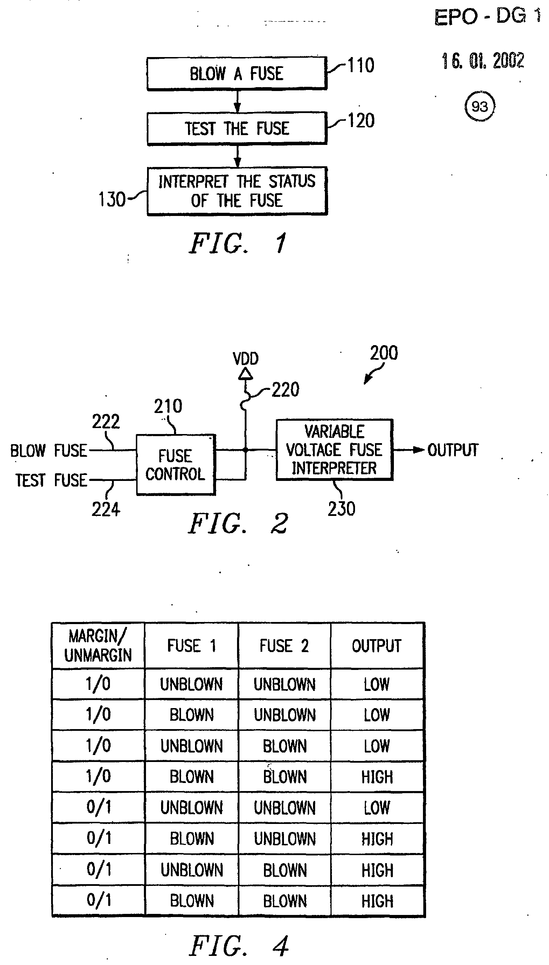

Referring to Figure 1 there is illustrated a block diagram of a method of fuse trimming in accordance with the present invention. In a first act, a trim fuse is blown or diffused 110 by passing a large current through the fuse. The large current causes the fuse link material to evaporate or diffuse. In a preferred embodiment, there are two trim fuses which form part of an integrated circuit in which the fuses are used to aid in compensating for manufacturing variations, for providing variable output responses and/or for selectively connecting additional elements to the integrated circuit. The fuses comprise polysilicon fuses which are formed on an insulator (e.g., silicon dioxide) in a preferred embodiment. The resistance of the fuses have a nominal value between 50 ohms and 400 ohms and preferably are between 250 ohms and 300 ohms. These values are chosen at least in part to allow bipolar transistors to supply current up to approximately 50 milliamps at a pulse length of approximately 1 millisecond, however, other combinations of current and pulse length can be chosen. Once a fuse is blown, the fuse has an open resistance of approximately greater than 100 kohms in a preferred embodiment.

In a second act, the fuses are tested 120 to insure that the fuses have been adequately diffused with a resistance greater than 100 kohms. If a fuse has not been adequately diffused, the fuse link material can grow back causing the fuse resistance to decrease. Circuitry is provided to generate a margin test current which is passed through the fuses. In a preferred embodiment, circuitry is also included to provide a second test current or operating current. The margin current is approximately 1/10th of the operating test current. Also, the test currents are not at a level that would blow a fully intact fuse.

In a third act, the status of the fuses are interpreted 130 to determine whether or not the fuses are blown. A variable voltage fuse interpreter is provided which allows for fuse interpretation at supply voltages ranging from approximately 4.5 to 8.8 volts. Thus, for example, an integrated fuse circuit, using the variable voltage fuse interpreter, is adaptable to both a writer circuit writing to a single head operating at approximately 8 volts and a writer circuit writing to multiple heads of a disk storage device operating at approximately 4.5 volts.

Referring now to Figure 2 there is illustrated a block diagram of a fuse circuit with a variable voltage fuse interpreter in accordance with the present invention. The fuse control 210 includes circuitry adapted to both blow a fuse 220 and to test the fuse 220 subsequent to diffusing. To initiate a diffuse current, a signal is received at input 222. The input signal can be received from an off-chip device. The block diagram illustrates a fuse circuit including only one fuse, however, multiple fuses can be included. Two fuses are included in a preferred embodiment with associated circuitry for blowing each fuse. Subsequent to receiving a signal to blow the fuse 220, a large current is passed through the fuse 220 causing the fuse link material to evaporate or diffuse. In a preferred embodiment, the fuse 220 comprises a polysilicon fuse which is formed on an insulator (e.g., silicon dioxide).

The fuse control 210 also includes circuitry adapted to pass test current through the fuse 220 and, in a preferred embodiment, includes circuitry to supply both an operating test current and a smaller margin current to each fuse. The margin current is as little as 1/10th the operating current and both circuits are adapted to operate with a VDD that can vary from approximately 4.5 volts to 8.8 volts.

The variable voltage fuse interpreter 230 includes logic circuitry adapted to determine the status of the fuse 220 (e.g., blown or unblown) as a test current passes through the fuse 220. The logic circuitry is adapted to operate at a VDD which can vary between 4.5 and 8.8 volts. The variable voltage fuse interpreter 230 outputs a digital response (e.g., high or low) corresponding to the fuse 220 status. In the preferred embodiment including two fuses, the logic circuitry is adapted to determine the status of both fuses at the operating test current and the smaller margin test current, and the digital response is set to a preselected output as a function of each fuse status at each test current. The fuse control 210, fuse 220 and variable voltage fuse interpreter 230 are integrated into a single semiconducting chip in a preferred embodiment and are all adapted to operate at a VDD ranging from approximately 4.5 to 8.8 volts. Thus, for example, the integrated chip is adapted to operated in circuits which write to a single head with an operating VDD of approximately 4.5 volts and in circuits which write to multiple heads in a corresponding disk storage device with an operating VDD of approximately 8.8 volts. Therefore, a need to design and manufacture a separate integrated circuit for each exemplary implementation is eliminated.

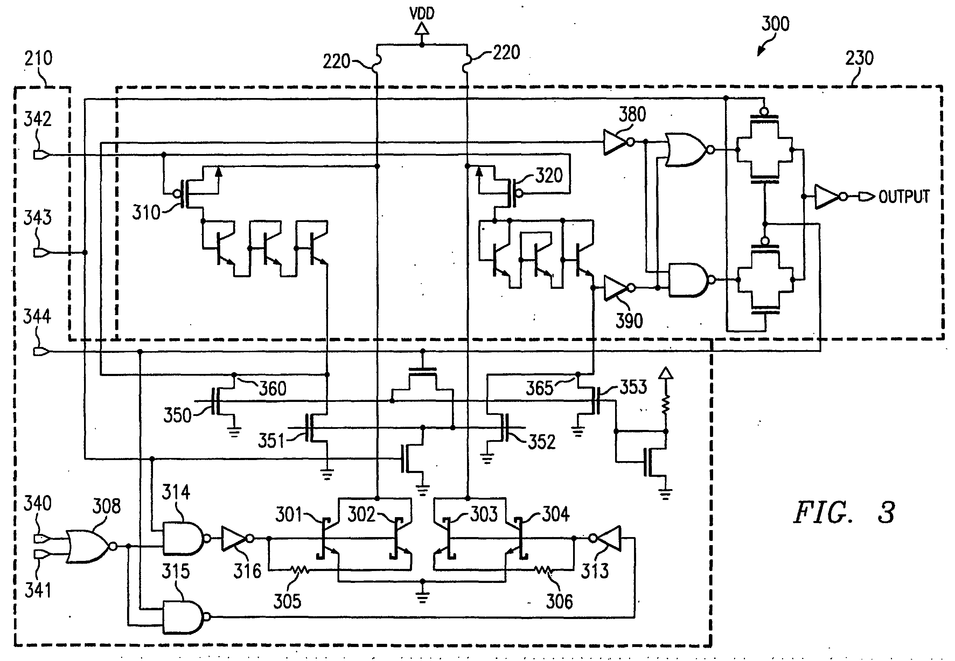

Referring now to Figure 3 there is illustrated a preferred embodiment of a fuse circuit in accordance with the present invention. The fuse control 210 circuit portion is generally enclosed in the dashed line box. The fuse control 210 includes circuitry adapted to both blow the fuses 220 and to test the fuses 220 subsequent to diffusing. In the preferred embodiment, each fuse is blown in a separate operation.

To blow a fuse, a large current (diffuse current) is passed through a selected fuse causing the fuse link material to evaporate or diffuse. In a preferred embodiment, the fuse 220 comprises a polysilicon fuse which is formed on an insulator (e.g., silicon dioxide). Passing of the diffuse current through the fuses 220 is controlled by bipolar transistor devices 301-302 and bipolar transistor devices 303-304. During the diffuse operation, switches 310 and 320 are turned off (input signal 342=high) such that only the current through bipolar transistor devices 301-304 pass through the fuse. The logic devices 308 and 313-316 select either bipolar transistor devices 301-302 or bipolar transistor devices 303-304 depending on the fuse selected (input signal 340=high); if the fuse is being blown (input signal 341 = high); and which of the two fuses 220 is being blown (either input signal 343 or input signal 344 = high but not both). Resistors 305-306 are designed to protect the base emitter junctions of the bipolar transistor devices 301-304.

To test the fuses 220, subsequent to diffusing, bipolar transistor devices 301-304 are turned off by logic devices 308 and 313-316 and switches 310 and 320 are turned on (input signal 342 = low). Thus, the fuses 220 are biased by current controlled by switches 350-353. A margin current test is performed (input signal 343=high, input signal 344 = low) in which switches 350 and 353 supply bias current, of approximately 1/10th of an operating test current, through a corresponding fuse 220. The interpreter logic of the variable voltage fuse interpreter 230 determines if both fuses 220 are blown (low voltage on both nodes 360 and 365). The variable voltage fuse interpreter portion of the circuit 300 is adapted to operate at VDD's varying from approximately 4.5 to 8.8 volts. This is accomplished by inverters 380 and 390 which are designed to have a threshold low enough, such that an unblown fuse will not trip the inverters 380 and 390 for supply voltages as low as 4.5 volts. Thus, circuit 300 is adapted to operate, for example, in circuits which write to a single head in a respective disk storage device with an operating VDD of approximately 8.8 volts and in a circuits which write to multiple heads with an operating VDD of approximately 4.5 volts. Therefore, the need to design and manufacture separate circuits for the above-described exemplary implementation is eliminated. Additionally, the fuse control 210, fuses 220 and variable voltage fuse interpreter 230 are integrated on a single semiconducting chip in a preferred embodiment.

Additionally, an operating or unmargin current test (input signal 343 = low, input signal 344 = high) is performed in which switches 350-353 supply bias current equivalent to the operating current through the fuses 220. In the unmargin test, the interpreter logic of the variable voltage fuse interpreter 230 determines if at least one of the two fuses 220 are blown (low voltage on either nodes 360 and 365). The variable voltage fuse interpreter 230 outputs a digital response (e.g., high or low) corresponding to the determined fuse status.

Referring now to Figure 4 there is illustrated a preferred embodiment of a control logic chart in accordance with the present invention. Note that the margin and unmargin tests are compliments such that when the margin input signal 343 is high the unmargin input signal 344 is low and when the margin input signal 343 is low the unmargin input signal 344 is high, where a "1" indicates high and "0" indicates low. Also, note that the digital output is high during a margin current test (margin = 1, unmargin = 0) only when both fuses 220 are determined to be diffused and the digital output is high during an unmargin current test (margin = 0, unmargin =1) when either of the two fuses 220 are determined to be blown.

Although a preferred embodiment of the apparatus and method of the present invention has been illustrated in the accompanied drawings and described in the foregoing Detailed Description, it is understood that the invention is not limited to the embodiments disclosed, but is capable of numerous rearrangements, modifications, and substitutions without departing from the spirit of the invention.

## Claims

1. A variable sensing fuse circuit, comprising:
a first fuse coupled to a variable power supply wherein said power supply varies between at least two voltage potentials;
a second fuse coupled to said variable power supply;
a first circuit portion for controlling a first current for diffusing said first and second fuse; and
a second circuit portion for interpreting a status of said first and second fuse, said second circuit portion further adapted to operate at said two voltage potentials.

2. A method of fuse trimming for a variable mode circuit, comprising:
blowing a first fuse, said first fuse electrically coupled to said variable mode circuit;
testing said first fuse at a first test current; and
interpreting a fuse status of said first fuse at said first test current.

3. The method of Claim 2 further comprising:
blowing a second fuse, said second fuse electrically coupled to said variable mode circuit; and
testing said second fuse at a first test current.

4. The method of Claim 2 or Claim 3 further comprising:
testing said first and second fuse at a second test current.

5. The method of any of Claims 2 to 4 further comprising:
providing a first test circuit adapted to control said first test current; and
providing an interpreting circuit portion adapted to provide a digital output indicative of said interpreted fuse status and adapted to operate at a plurality of voltage modes.

6. The method of Claim 5 further comprising:
integrating said first fuse, first test circuit and interpreting circuit portion in a semiconductor device, wherein said integrated semiconductor device is adapted to operate at said plurality of voltage modes.

7. The method of any of Claims 2 to 6 further comprising:
interpreting a fuse status of said first and second fuse at said first and second test current.

8. The method of any of Claims 5 to 7, wherein said interpreting circuit portion further comprises:
logic circuitry adapted to control said digital output as a predetermined function of said first and second fuse status at each of said first and second test current.

9. The method of Claim of 8, wherein said predetermined function of said digital output comprises:
a high indication for said first test current when said first and second fuse is determined to be blown; and
a high indication for said second test current when at least one of said first and second fuse is determined to be blown.
